# EUROPÄISCHE PATENTSCHRIFT

(11) **EP 1 860 499 B1**
(45) Veröffentlichungstag und Bekanntmachung des Hinweises auf die Patenterteilung: **11.02.2015**
(21) Anmeldenummer: 07014526.3
(22) Anmeldetag: 03.11.1997
(51) Int. Cl.: G03F 7/20, G03F 7/095, G03F 7/12

(54) **Verfahren zum Herstellen einer Druckform**
Process for making a printing form
Procédé pour fabriquer un cliché d'impression

(43) Veröffentlichungstag der Anmeldung: 28.11.2007
(62) Teilanmeldung aus: 97119181.2
(73) Patentinhaber: SPGPrints B.V., 5831 AT Boxmeer (NL)
(72) Erfinder: Rückl, Siegfried, 6330 Kufstein (AT)
(74) Vertreter: Ter Meer Steinmeister & Partner

(56) Entgegenhaltungen:
- EP-A- 0 001 030
- EP-A- 0 065 760
- EP-A- 0 264 845
- EP-A- 0 598 926
- EP-A- 0 785 474
- EP-A- 0 803 772
- DE-A- 4 203 554
- DE-A- 4 243 750
- DE-A- 4 339 010
- DE-A- 19 536 805
- DE-A- 19 536 806
- DE-A1- 4 023 586
- US-A- 5 024 919
- US-A- 5 495 803

## Beschreibung

Die Erfindung betrifft ein Verfahren zum Herstellen einer Siebdruckform.

Bei der Herstellung von Siebdruckschablonen ist es bekannt, auf ein als Träger der Druckform oder -schablone dienendes Sieb einen photoempfindlichen Lack aufzutragen, zu belichten und anschließend zu entwickeln, um die Photolackschicht in Bereichen, in denen später beim Drucken Farbe durch das Sieb übertragen werden soll, zu entfernen. Die musterbedingte Belichtung der Photolackschicht erfolgt dabei beispielsweise durch einen auf den Rohling der Druckform aufgelegten Großfilm oder punktweise mit Hilfe von Laserlicht, wobei die gesamte Photolackschicht punktweise abgetastet und nur an den Stellen belichtet wird, an denen die chemische Struktur des Photolacks für die spätere Entwicklung musterbedingt verändert werden soll. Ferner ist es bekannt, die Photolackschicht mit einem CO₂-Laser mustergemäß abzudampfen.

Sowohl die Verwendung von Großfilmen als auch der Einsatz von Lasern, insbesondere von CO₂-Lasern, die einen sehr hohen Energieverbrauch aufweisen, verteuert die Herstellung von Siebdruckschablonen.

Bei der Herstellung einer einer Flexodruckform, wird ein strahlungs- oder photoempfindliches Material, beispielsweise ein Photopolymer oder Photoelastomer zunächst auf einen Träger aufgebracht. Dann wird durch musterbedingtes Bestrahlen oder Belichten einzelner Bereiche der Schicht wird das Polymer vernetzt. Für die Belichtung wird vorzugsweise ultraviolette Strahlung verwendet. Anschließend werden in einem geeigneten Entwickler die nichtbelichteten und damit nichtvernetzten Polymerbereiche ausgewaschen. Gegebenenfalls wird mit einer im UV-Bereich emittierenden Strahlungsquelle die Photopolymerschicht nachbelichtet und dadurch intensiver vernetzt.

Bei den bisher bekannten Verfahren werden die mustergemäß nicht zu belichtenden Bereiche der strahlungsempfindlichen Schicht, also insbesondere der Photoelastomerschicht, entweder wie bei Siebdruckschablonen durch einen Ganzfilm oder durch eine mittels Düsen musterförmig aufgespritzte Schicht abgedeckt.

Bei der Abdeckung der strahlungsempfindlichen Schicht durch einen photographisch hergestellten Ganzfilm ist bei zylindrischen Druckformen eine Nahtstelle im Muster meistens nicht zu vermeiden. Auf jeden Fall verteuert ein derartiger Ganzfilm, der die Größe der Druckform und bei zylindrischen Druckformen also die Größe der Zylinderoberfläche aufweisen muß, die Herstellung von Druckformen erheblich.

Das mustergemäße Aufspritzen einer abdeckenden, lichtabsorbierenden und/oder lichtreflektierenden Farbschicht mit Hilfe von Düsen auf eine strahlungsempfindliche Schicht verlangt nach hochreinen Abdecktinten, die hinreichend auf der strahlungsempfindlichen Schicht haften und trotzdem die verwendeten Düsen nicht verstopfen. Neben den hohen Anforderungen an die Abdecktinten müssen auch die zum Aufspritzen verwendeten Düsen hohe Anforderungen erfüllen, da je Zeiteinheit viele Tropfen mit gleichbleibender Größe zu erzeugen sind.

Durch das mustergemäße Aufspritzen von Abdecktinte auf die Oberfläche einer Druckform, insbesondere auf eine Zylinderoberfläche, lassen sich zwar die Probleme, die bei der Handhabung von Großfilmen auftreten vermeiden, jedoch erfordert die Aufspritztechnik sehr präzise Düsen, die aufwendig herzustellen und zu steuern sind.

Die DE 195 36 806 A1 beschreibt ein Verfahren zur Herstellung von photopolymeren Tiefdruckplatten. Bei diesem Herstellungsverfahren werden auf einem dimensionsstabilen Träger übereinander eine durch aktinische Strahlung vernetzbare Schicht, eine gegen IR-Strahlung empfindliche Schicht, gegebenenfalls eine zwischen der durch aktinische Strahlung vernetzbaren Schicht und der gegen IR-Strahlung empfindlichen Schicht angeordnete Trennschicht, sowie eine auf der gegen IR-Strahlung empfindlichen Schicht angebrachte abziehbare Schutzfolie aufgebracht.

Bei der durch aktinische Strahlung vernetzbaren, d. h. photostrukturierbaren, reliefbildenden Schicht handelt es sich um ein Gemisch aus mindestens einem in Wasser oder Wasser/Alkohol-Gemischen löslichen oder dispergierbaren polymeren Bindemittel, mit diesem polymeren Bindemittel verträglichen copolymerisierbaren ethylenisch ungesättigten organischen Verbindungen, einem Photoinitiator oder Photoinitiatorsystem, sowie gegebenenfalls weiteren Hilfs- und Zusatzstoffen. Auf der photostrukturierbaren Schicht befindet sich die gegen IR-strahlungsempfindliche Schicht, die laserablatierbar ist sowie gegebenenfalls eine Zwischenschicht aus einem sauerstoffdurchlässigen entwicklerlöslichen oder -dispergierbaren Polymer. Eine derartige Zwischenschicht vermag die Diffusion von Monomeren aus der lichtempfindlichen, photopolymerisierbaren Schicht in die darüberliegende IR-lichtempfindliche Schicht zu verringern und die lichtempfindliche, photopolymerisierbare Schicht gegen die Einwirkung des Laserstrahls bei der Laserablation zu schützen. Darüber hinaus ist diese Zwischenschicht durchlässig gegenüber Luftsauerstoff, so dass während der der Laserablation folgenden UV-Belichtung Luftsauerstoff zutreten kann und damit eine genauere Steuerung der Näpfchentiefe erzielt wird.

Die EP 0 785 474 A1 beschreibt ein Verfahren und eine Vorrichtung zur Herstellung einer Flexodruckschablone. Hierbei wird bei einem Metallrohr ein noch vollständig vernetztes, plattenförmiges Photoelastomer aufgebracht, über welchem eine hochlichtempfindliche, dünne Schicht gelegt ist. Nach einem punktförmigen Belichten der hochlichtempfindlichen Schicht mittels eines Lasers entsprechend einem Muster erfolgt die Entwicklung der äußeren dünnen lichtempfindlichen Schicht z. B. durch peripheres Eintauchen der Druckform in ein alkalisches Bad. Bei der Verwendung von Gelatine- oder Polyvinylalkoholschichten, welche Silberhalogenid-Kristalle enthalten, enthält die alkalische Entwicklerflüssigkeit zusätzlich ein organisches Reduktionsmittel zur Reduktion der belichteten Silberhalogenide zu nicht löslichem, metallischen Silber. Hierin wird die großflächige Belichtung der Druckform gezeigt, also die großflächige Belichtung der Photoelastomerschicht, welche auf ihrer Oberfläche jetzt die lichtundurchlässige Maske trägt. Hierbei werden Stellen des Photoelastomers, welche nicht durch UV-Strahlung permanent vernetzt wurden, in einem Spülbecken durch eine zweite Entwicklerflüssigkeit aus dem Polymerverband herausgelöst. Bei diesem Entwickler handelt es sich um ein Gemisch aus Butanol und Perchlorethylen.

Die DE 42 03 554 A1 beschreibt ein Verfahren zur filmlosen Herstellung von flexiblen Druckformen. Bei diesem Verfahren werden flexible Druckformen aus Druckplatten hergestellt, die im Wesentlichen aus einem formstabilen Träger, einer lichtempfindlichen Aufzeichnungsschicht und einer eingefärbten Deckfolie bestehen. Die Strukturierung der Druckplatte erfolgt filmlos, indem die eingefärbte, aktinische lichtabsorbierende Deckfolie bildmäßig geschnitten wird, die ausgeschnittenen Bildstellen der einfärbten Deckfolie abgezogen werden und die Druckplatte anschließend belichtet wird. Danach wird die eingefärbte Deckfolie entfernt und schließlich die nicht belichteten Teile der Aufzeichnungsschicht in einem geeigneten Entwickler ausgewaschen. Die nach diesem Verfahren hergestellten Druckformen eignen sich zur Herstellung von Flexodruckerzeugnissen und zur Lackierung von Offset-Druckerzeugnissen.

Die US 5,024,919 A beschreibt ein Verfahren zum Herstellen eines feinen Musters in einer Halbleitervorrichtung. Bei diesem Verfahren zur Bildung eines Feinmusters in einer Halbleitervorrichtung wird eine obere Polymerschicht auf einer unteren Photolackschicht ausgebildet, wobei die obere Polymerschicht nach Bestrahlung mit ultraviolettem Licht lichtundurchlässig für tiefultraviolettes Licht wird. Die untere Lackschicht ist photosensitiv auf tiefultraviolettes Licht. Nachdem die obere Polymerschicht mittels einer Maske ultraviolettem Licht ausgesetzt wurde, dient die obere Polymerschicht als Maske für die darunter liegende Photolackschicht, da die belichteten Bereiche opak für tiefultraviolettes Licht sind. Nach dem Entfernen der oberen Polymerschicht und einer gegebenenfalls verwendeten Zwischenschicht wird die darunter liegende Lackschicht entwickelt, um ein Muster zu bilden.

Die EP 0 065 760 A2 beschreibt einen Photobelichtungsprozess. Hierin werden magnetische Tonerteilchen, welche an einem magnetischen Element mit einer Polymerträgerschicht und einer Magnetschicht in Bereichen anhaften, in welchen die Magnetschicht magnetisiert ist, auf ein Substrat mit einer darüber liegenden photosensitiven Schicht und einer transparenten Abdeckschicht übertragen. Nach Bestrahlung des Substrats mit der darauf liegenden photosensitiven Schicht und der Abdeckschicht wirken die auf die Abdeckschicht übertragenen Tonerteilchen als Maske. Durch die Bestrahlung der photosensitiven Schicht werden bestrahlte Bereiche polymerisiert und verbleiben nach einem Abziehen der Deckschicht und einem Entwicklungsprozess auf dem Substrat.

Die DE 43 39 010 A1 beschreibt Druckplatten, auf die ein Bild mit einem Laser übertragbar ist. Hierbei werden flexographische Druckplatten und ein Verfahren zu deren Herstellung offenbart, auf die ein gewünschtes Bild mittels Laser übertragen wird. Ein dünner Polymerfilm dotiert mit einem UV-Absorber wird auf einer Photopolymerschicht laminiert. Der Film wird unter Verwendung eines Lasers, der bei einer ausgewählten Wellenlänge arbeitet, von dem Photopolymer abgeschmolzen, wobei ein in situ Negativ erzeugt wird. Das resultierende Negativ kann der typischen Belichtung mit UV-Flutlicht und Entwicklung unterworfen werden.

Die DE 195 36 805 A1 beschreibt ein zur Herstellung von Flexodruckplatten durch digitale Informationsübertragung geeignetes mehrschichtiges Aufzeichnungselement. Hierbei wird auf einem dimensionsstabilen Träger eine gegebenenfalls mit dem dimensionsstabilen Träger durch eine Haftschicht verbundene, durch aktinische Strahlung vernetzbare Schicht, eine gegen IR-strahlungsempfindliche Schicht sowie gegebenenfalls eine abziehbare Deckfolie übereinander angeordnet. Die durch die aktinische Strahlung vernetzbare Schicht ist nach bildmäßiger Belichtung durch Entwickler auswaschbar und besteht im Wesentlichen aus einem Gemisch aus mindestens einem elastomeren Bindemittel, ethylenisch ungesättigten copolymerisierbaren organischen Verbindungen, einen Photoinitiator oder Photoinitiatorsystem sowie gegebenenfalls weiteren Hilfsstoffen. Die gegen IR-Strahlung empfindliche Schicht ist eine in Entwickler lösliche oder dispergierbare Schicht, die in einem Film bildenden Bindemittel mit elastomeren Charakter mindestens eine feinverteilte Substanz enthält, die eine hohe Absorption im Wellenlängenbereich zwischen 750 und 20000 nm hat. Hierbei sind als Entwickler sowohl für die durch aktinische Strahlung vernetzbare Schicht als für die gegen IR-strahlungsempfindliche Schicht Wasser oder Alkohol/Wasser-Gemische geeignet.

Die DE 42 43 750 A1 beschreibt ein Verfahren zur Herstellung einer Druckform für den Tiefdruck, Siebdruck, Flexodruck oder Offsetdruck. Hierbei weist ein Druckzylinder eine photopolymere Schicht und eine äußere sensitive Beschichtung auf, wobei bei Bestrahlung mittels eines Lasers die äußere sensitive Beschichtung in von einem Laserstrahl getroffenen Bereichen durch die Wärmeeinwirkung verdampft. In einem folgenden Verfahrensschritt wird mittels einer weiteren Strahlquelle, die einen Strahl größerer Lichtstärke aussendet, durch die Photomaske der Beschichtung hindurch die photopolymere Schicht belichtet. In den lichtdurchlässigen Bereichen der Beschichtung dringt der Strahl in die photopolymere Schicht und bewirkt dort eine Photopolymerisation. In einem anschließenden Verfahrensschritt werden dann mittels bekannter Entwicklungs- oder Ablöseprozesse die Beschichtung vollständig und in den unbelichteten, d. h. chemisch nicht veränderten Bereichen die photopolymere Schicht entfernt, während die belichteten Bereiche der photopolymeren Schicht aufgrund ihrer durch die Belichtung geänderten chemischen Eigenschaften in diesem Entwicklungs- oder Ablöseprozess nicht entfernt werden, sondern auf der Oberfläche des Zylinders verbleiben.

Die EP 0 598 926 A1 beschreibt ein Verfahren und eine Vorrichtung zur Herstellung von Flexodruckformen. Hierin besteht eine Druckschablone aus einem mit einer Photoelastomerschicht bedeckten Zylinder, wobei die Photoelastomerschicht mit einem Muster bedeckt und anschließend belichtet wird, um die nicht vom Muster bedeckten Bereiche durch diese Belichtung zu vernetzen. Danach werden die unbelichteten Bereiche der Photoelastomerschicht ausgewaschen. Zur Erzeugung des Musters wird eine Abdeckflüssigkeit auf die Oberfläche der Photoelastomerschicht aufgebracht, z. B. mit Hilfe von Elektrostatikdüsen aufgespritzt.

Die DE 40 23 586 A1 beschreibt eine lichtempfindliche Siebdruckmasse und deren Verwendung. Hierbei besteht eine lichtempfindliche Siebdruckmasse aus einem Gemisch wenigstens einer im wesentlichen wasserlöslichen Bindemittelharzkomponente, einer empfindlichen Komponente aus dem Kondensationsprodukt eines 4-Diazodiphenylamins mit Formaldehyd und wenigstens einem Kondensationsprodukt des 4-Diazodiphenylamins mit einem Kondensationsmittel der Formel E(-CHRₐ-OR_{b})ₘ und Wasser.

Davon ausgehend liegt der Erfindung die Aufgabe zugrunde, ein weiteres Verfahren zum Herstellen einer Druckform bereitzustellen, das einfach und kostengünstig auszuführen ist und dabei mustergetreue Druckformen liefert.

Diese Aufgabe wird durch das Verfahren nach Anspruch 1 gelöst. Vorteilhafte Ausgestaltungen und Weiterbildungen des erfindungsgemäßen Verfahrens sind in den Unteransprüchen beschrieben.

Es wird also bei der Herstellung der Druckform auf eine strahlungsempfindliche Schicht aus einem vernetzbaren Lack eine strahlungs- bzw. lichtdichte Abdeckschicht aufgetragen. Durch eine anschließende Strukturierung der Abdeckschicht entsprechend einem Muster wird eine Bestrahlungs- oder Belichtungsmaske unmittelbar auf der strahlungsempfindlichen Schicht ausgebildet. Anschließend erfolgt dann in gewohnter Weise die Belichtung und Entwicklung der strahlungsempfindlichen Schicht.

Bei dem erfindungsgemäßen Verfahren wird also die mustergemäße Belichtungsmaske unmittelbar auf der zu belichtenden Schicht ausgebildet, wobei zunächst die zu belichtende Schicht vollständig mit der Abdeckschicht abgedeckt wird, um diese dann zu strukturieren. Bei der Auswahl des Abdeckschichtmaterials brauchen daher nur die Hafteigenschaften sowie die Strahlungsabsorbtions- und -reflektionseigenschaften berücksichtigt zu werden. Die Absorbtions- und/oder Reflektionsfähigkeit der Abdeckschicht ist dabei auf die Strahlungsempfindlichkeit der ersten strahlungsempfindlichen Schicht abzustimmen. Obwohl es ausreicht, wenn die Abdeckschicht nur die zum Belichten der ersten strahlungsempfindlichen Schicht verwendete Strahlung vollständig abblockt, ist es vorteilhaft, wenn sie auch in den benachbarten Strahlungsbereichen ein gutes Absorbtions- bzw. Reflektionsvermögen aufweist.

Das erfindungsgemäße Verfahren läßt sich bei der Herstellung von galvanoplastisch geformten Sieben einsetzen. Hierbei wird dann die erste strahlungsempfindliche Schicht, die auf einer vollflächigen, leitenden, insbesondere metallischen Oberfläche angeordnet ist, entsprechend dem galvanisch herzustellenden Sieb gemustert.

Das erfindungsgemäße Verfahren läßt sich weiter vereinfachen, wenn vorgesehen wird, daß die mustergemäß strukturierte Abdeckschicht, also die Bestrahlungsmaske beim Entwickeln der ersten strahlungsempfindlichen Schicht entfernt wird wobei mechanische und/oder chemische Mittel eingesetzt werden. Hierdurch wird ein zusätzlicher das Verfahren unnötig komplizierender Bearbeitungsschritt zum separaten Entfernen der Abdeckschicht nach dem Belichten vermieden.

Zweckmäßigerweise ist bei dem erfindungsgemäßen Verfahren vorgesehen, daß zur Strukturierung der Abdeckschicht musterbedingt zu entfernende Teile der Abdeckschicht unmittelbar abgetragen werden.

Zum mustergemäßen Abtragen der Abdeckschicht Laserstrahlung wird verwendet. Laserstrahlung hat den Vorteil, daß sich sehr kleine Lichtflecke mit hoher Intensität zum Abtragen der Abdeckschicht einfach ausbilden und handhaben lassen.

Eine besonders mustergetreue Druckform oder Galvanisierform für Trägersiebe wird erhalten, wenn vorgesehen ist, daß die mustergemäße Bestrahlung der Abdeckschicht bzw. der zweiten strahlungsempfindlichen Schicht punktweise erfolgt. Hierbei läßt sich die Zeit für die erste Belichtung, also für die Belichtung der zweiten strahlungsempfindlichen Schicht deutlich verkürzen, wenn bei der punktweisen Bestrahlung mehrere nebeneinander liegende Musterpunkte mittels einer entsprechenden Anzahl von Bestrahlungspunkten gleichzeitig mustergemäß bestrahlt werden.

Besonders gute Abschirmeigenschaften werden erreicht, wenn die Abdeckschicht feine lichtabsorbierende und/oder lichtreflektierende Partikel, insbesondere Ruß (Black Carbon) oder feine Metallpartikel, Pigmente und/oder strahlungsabsorbierende Chemikalien enthält.

Erfindungsgemäß sind die feinen lichtabsorbierenden oder lichtreflektierenden Partikel in Gelatine oder Polyvinylalkohol suspendiert.

Wenn die Abdeckschicht als lichtabsorbierende und -reflektierende Mittel feine Metallpartikel enthalten soll, ist es zweckmäßig, wenn die Suspension von feinen Metallpartikeln in Gelatine durch Reduktion von in Gelatine gelösten Metallsalzen, insbesondere Silberhalogeniden, hergestellt wird. Hierdurch wird die Arbeitssicherheit bei dem erfindungsgemäßen Verfahren deutlich verbessert, da sehr feine Metallpartikel leicht entzündlich und hochexplosiv sind.

Besonders einfach läßt sich die Abdeckschicht mit einem Tauchbeschichtungsverfahren auftragen, insbesondere wenn die gewünschte Abdeckschicht 1 µm bis 20 µm, vorzugsweise 7 µm bis 14 µm, insbesondere 10 µm dick sein soll.

Bei der Herstellung von Siebdruckschablonen oder Matrizen zur galvanischen Herstellung von Trägersieben ist es zweckmäßig, wenn die erste strahlungsempfindliche Schicht eine Photolackschicht ist, die vorzugsweise mit einem Tauchbeschichtungsverfahren auf den Träger aufgebracht wird. Zweckmäßigerweise lassen sich dabei sowohl Photo-lacke auf der Basis von Gelatine oder Polyvinylalkohol als auch Photolacke auf Kunstharzbasis,einsetzen. Um eine Rissbildung beim Trocknen oder Aushärten der Photolacke oder bei der späteren Benutzung der fertigen Druckform zu verhindern, ist erfindungsgemäß vorgesehen, daß der Photolackschicht Stoffe zum Vergrößern ihrer Elastizität beigefügt sind. Insbesondere bei der Verwendung von Fotolacken auf Gelatine- oder Polyvinylalkohol können dem Photolack Weichermacher, z. B. Glyzerin oder Glykol. beigemengt sein.

Für flache oder ebene Siebdruckschablonen ist es zwecksmäßig, wenn der Träger aus einem Textilgewebe, insbesondere aus einem Seidengasegewebe, gebildet ist. das vorzugsweise durch eine chemische und/odergalvanische Metallabscheidung verstärkt ist. Durch die Metallabscheidung wird das besonders feine Gewebe nicht nur mechanisch verstärkt, sondern es wird auch dessen Reflexionsfähigkeit für Strahlung verbessert, so daß das Siebgewebe beim Abtragen der Abdeckschicht und der Belichtung der ersten strahlungsempfindlichen Schicht nicht beschädigt wird, wenn die hierfür jeweils verwendete Strahlung etwas zu hoch dosiert ist.

Die Erfindung wird im folgenden beispielsweise anhand der Zeichnung näher erläutert. Es zeigen:
**Fig.1** einen achsparallelen Längsschnitt durch einen zylindrischen Rohling zur Herstellung einer Druckform gemäß einem allegemeinen Beispiel zum besseren verständnis der Erfindung,
**Fig.2** eine Schnittdarstellung entsprechend Fig.1 der Rohlings nach einer ersten Belichtung und Entwicklung.
**Fig.3** eine Schnittdarstellung des Rohlings nach Fig.2 bei einer zweiten Belichtung,
**Fig.4** eine Schnittdarstellung der fertiggestellten zylindrischen Druckform nach der letzten Entwicklung.
**Fig.5** eine Vorrichtung zur mustergemäßen Belichtung eines Rohlings für eine Druckform,
**Fig.6** eine Vorrichtung zur Entwicklung des Rohlings nach der ersten Belichtung,
**Fig.7** eine Vorrichtung zur großflächigen Belichtung des Rohlings,
**Fig.8** eine Vorrichtung zur Entwicklung des Rohlings nach der großflächigen Belichtung,
**Fig.** 9 einen achsparallelen Längsschnitt durch einen zylindrischen Rohling zur Herstellung einer Siebdruckschablone gemäß einem Ausführungsbeispiel der Erfindung,
**Fig. 10** eine vergrößerte Schnittdarstellung des beschichteten Siebs aus Figur 1,
**Fig. 11** eine vergrößerte Schnittdarstellung eines Siebs mit einer anderen Beschichtung.
**Fig. 12** eine Darstellung des Siebs gemäß Figur 2 beim Abtragen einer Abdeckschicht zur Strukturierung einer Bestrahlungsmaske.
**Fig. 13** eine Schnittdarstellung des Rohlings nach Figur 9 während einer Belichtung,
**Fig. 14** eine vergrößerte Schnittdarstellung des fertigen Siebs nach der Entwicklung,
**Fig. 15** eine Vorrichtung zum mustergemäßen Abtragen der Abdeckschicht auf einem zylindrischen Rohling,
**Fig. 16** eine Vorrichtung zur großflächigen Belichtung des Rohlings und
**Fig. 17** eine Vorrichtung zur Entwicklung des Rohlings nach der Belichtung.

In den verschiedenen Figuren der Zeichnung sind einander entsprechende Teile mit gleichen Bezugszeichen versehen.

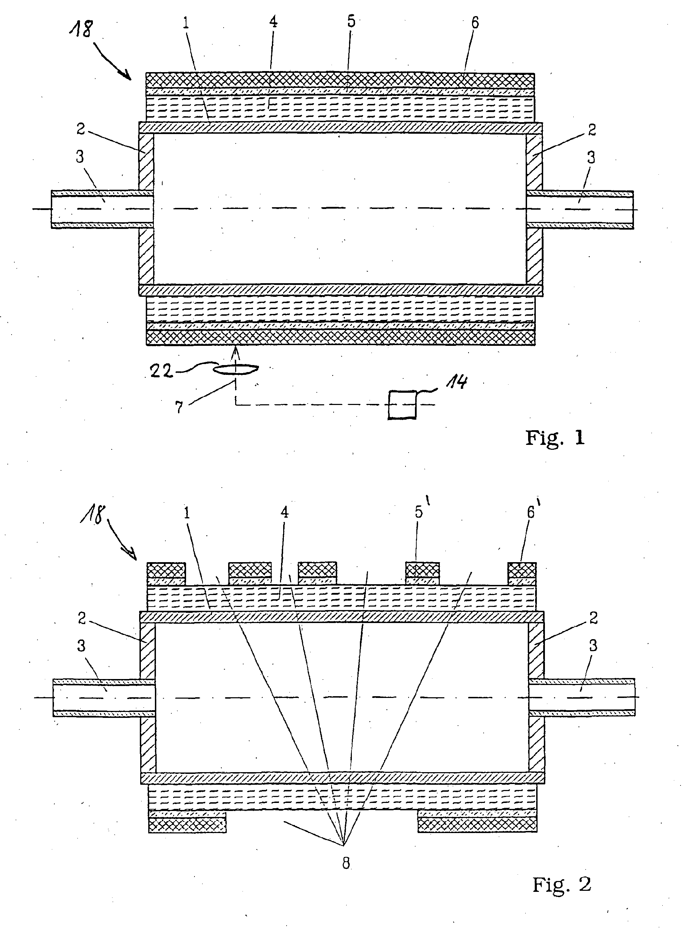

Ein in Fig.1 gezeigter Rohling für eine Druckform, der im folgenden unabhängig von der Herstellungsstufe der Einfachheit halber als Druckform 18 bezeichnet wird, weist ein Trägerrohr 1 auf, an dessen Stirnseiten Deckplatten 2 und Achsstummel 3 eingeschweißt oder eingeklebt sind. Die Achsstummel 3 dienen dabei zur späteren Einspannung der Druckform 18 auf einer Druckmaschine.

Auf dem Trägerrohr 1 ist eine erste strahlungsempfindliche Schicht, insbesondere eine Photopolymerschicht, vorzugsweise eine Photoelastomerschicht 4 mit einer Dicke von vorzugsweise 2 bis 5 mm aufgebracht. Im allgemeinen wird diese Photoelastomerschicht 4 aus einer Photoelastomerplatte, z.B. Nyloprint, aufgebaut, die um das Trägerrohr 1 gewickelt wird. Das Photoelastomer dieser Platte weist zunächst nur einen niedrigen Polymerisationsgrad auf und ist daher sowohl elastisch als auch plastisch verformbar und verklebt bei Wärmeeinwirkung mit dem Trägerrohr 1 und an der Stoßstelle mit sich selbst bei Temperaturen von etwa 120°C. Hierbei erfolgt noch keine Vernetzungsreaktion, so daß die Strahlungs- oder Lichtempfindlichkeit der auf dem Trägerrohr 1 aufgebrachten Photoelastomerschicht 4 nicht beeinträchtigt wird.

Anstelle der mit 2 bis 5 mm relativ dicken Photoelastomerschicht 4, wie sie für Flexodruckformen eingesetzt wird, kann auch als erste strahlungsempfindliche Schicht beispielsweise eine dünne Photolackschicht oder dergleichen vorgesehen werden, wenn eine Siebdruckform mit dem erfindungsgemäßen Verfahren hergestellt werden soll. Dabei ist anstelle des Trägerrohrs 1 dann ein entsprechender Siebzylinder vorzusehen.

Auf die Photoelastomerschicht 4 wird nun eine Abdeckschicht 5 z.B. mittels Tauchbeschichtung aufgetragen. Dabei wird beispielsweise eine wässrige Lösung von Gelatine oder Polyvinylalkohol aufgebracht, der etwa 10 Gew.-% Ruß (Black Carbon) beigefügt ist. Es kann aber auch eine Gelatine verwendet werden, in der feinste Metallpartikel suspendiert sind. Da derartig kleine Metallpartikel hochexplosiv sind. kann die Suspension durch eine Reduktion von in Gelatine gelösten Metallsalzen, z.B. Silberhalogeniden, hergestellt werden. Die die auf diese Weise erzeugten feinsten Metallpartikel umgebende Gelatine verhindert dann deren Oxidation und somit eine Explosion.

Bei derTauchbeschichtung zum Auftragen der Abdeckschicht 5 wird über die mit senkrechter Achse angeordnete Druckform 18 eine Ringrakel (nicht dargestellt) von oben nach unten gezogen, wobei sich erwärmte Gelatinelösung im Ringraum zwischen der Ringrakel und der Photopolymerschicht 4 befindet und bei der Abwärtsbewegung als dünner Film auf der Oberfläche der Photopolymerschicht 4 haften bleibt. Die Dicke dieses Films kann durch die Temperatur der Gelatinelösung, durch den Feststoffanteil, also durch den Anteil von Ruß oder Metallpartikel in der Gelatinelösung, die Intensität einer gegebenenfalls gleichzeitig erfolgenden Kühlung durch einen Kaltluftstrom und die Geschwindigkeit der Abwärtsbewegung variiert werden.

Bei der rasch erfolgenden Abkühlung des Gelatine- oder Polyvinylalkoholfilms erstarrt dieser und wird in einem nachfolgenden Zwischentrocknungsvorgang von seinem Wasseranteil befreit. Durch den Zusatz von geringen Anteilen von Weichmachern, z.B. Glyzerin oder Glykol, kann der Gelatine- oder Polyvinylalkoholfilm auch nach der Trocknung soweit elastisch gehalten werden, so daß Rißbildungen in der trocknenden Schicht, also in der sich bildenden Abdeckschicht 5 verhindert werden können. Sofern erforderlich kann auch eine Gerbung der Abdeckschicht 5 durch Besprühen mit Formaldehyd oder Alaunlösung erfolgen. Hierbei ist jedoch zu berücksichtigen, daß sich die Abdeckschicht 5 in einem späteren Verfahrensschritt leichter bzw. schneller entfernen läßt, wenn die Gelatine oder Polyvinylalkohol nicht gegerbt wird.

Nach dem Ausbilden der Abdeckschicht 5 wird als dritte Schicht eine zweite strahlungsempfindliche Schicht, insbesondere eine photoempfindliche Schicht, vorzugsweise eine Photolackschicht 6 aufgetragen. Als Photolack fürdiePhotolackschicht 6 kann dabei entweder ein lichthärtbarer oder ein durch Licht zersetzbarer Photolack verwendet werden. DasAufbringen der Photolackschicht 6 erfolgt dabei zweckmäßigerweise ebenfalls im Tauchbeschichtungsverfahren. Der Photolack für die Photolackschicht 6 liegt meist in alkoholischer oder ketonischer Lösung vor. Diese Lösungsmittel quellen eine Gelatineschicht nicht an. Es können aber auch wässrige Emulsionen von Photolacken verwendet werden, wenn nach dem Kontakt der Abdeckschicht 5 mit der Photolackemulsion bis zur erfolgten Trocknung der Photolackschicht 6 jede weitere mechanische Berührung der beschichteten Druckformoberfläche vermieden wird.

Nach Trocknung der Photolackschicht 6 wird diese entsprechend einem später mit der Druckform 18 zu druckendem Muster bestrahlt. Hierfür wird eine Strahlung verwendet, für die die zweite strahlungsempfindliche Schicht empfindlich ist. Bei der hier beschriebenen Photolackschicht 6 erfolgt die Bestrahlung also mit Hilfe eines Lichtstrahls, insbesondere mit Hilfe eines Laserstrahls. Je nach dem verwendeten Photolack kann als Licht für die Belichtung der Photolackschicht 6 ultraviolettes oder sichtbares Licht verwendet werden. Beispielsweise ist es möglich die Belichtung der Photolackschicht 6 mit Hilfe eines Lasers, dessen Licht im UV-Blau- oder Grünbereich liegt, insbesondere mit Hilfe eines Argon-Ionen-Lasers durchzuführen, dessen Wellenlänge mit 488 nm im sichtbaren Blaubereich liegt.

Ein Vorteil der Belichtung mit der genannten Wellenlänge ist, daß eine Vorvernetzung der unter der Photolackschicht 6 liegenden Photoelastomerschicht 4 kaum erfolgt, da für eine Vernetzung dieser Photoelastomerschicht 4 Licht mit höherer Quantenenergie und somit kürzerer Wellenlänge, also Licht des ultravioletten Spektralbereichs erforderlich ist. Um die verwendete Laserstrahlung sehr gut absorbieren zu können, kann es bei bestimmten Zusammensetzungen der Abdeckschicht erforderlich sein, daß ein weiteres Pigment zugesetzt wird.

Der Laserstrahl 7 wird an seiner Auftreffstelle auf die Photolackschicht 6 der Druckform 18 durch eine Linsenanordnung oder eine Laseroptik 22 auf einen Strahldurchmesser von etwa 20 bis 30 µm fokussiert. Die Belichtung erfolgt entsprechend dem zu druckenden Muster, das heißt der Laserstrahl 7 wird durch eine entsprechende Anordnung mit Blendenfunktion an den nicht zu belichtenden Stellen unterbrochen. Beispielsweise kann für die Unterbrechung des Laserstrahls 7 ein akustooptischer oder elektrooptischer Schalter 14 eingesetzt werden. Bei dieser Methode der optischen Steuerung des Laserstrahls 7 können pro Sekunde etwa 10⁶ Musterpunkte belichtet werden.

Nach der Belichtung wird die Photolackschicht 6 entwickelt. Bei dieser ersten Entwicklung wird, falls ein lichthärtbarer Photolack, also ein Negativlack, für die Photolackschicht 6 verwendet wurde der nichtbelichtete und somit unvernetzte Photolack ausgewaschen. Dies geschieht üblicherweise mit einem auf dem verwendeten Photolack abgestimmten Entwickler. Zweckmäßigerweise kann ein alkalischer Entwickler mit etwa 2% Soda und gegebenenfalls ebenso geringen Anteilen an Natron- oder Kalilauge verwendet werden. Bei dieser Entwicklung wird nach dem Auswaschen der unvernetzten Photolackschicht auch die dann nicht mehr abgedeckte Abdeckschicht 5 durch den alkalischen Entwickler aufgelöst und abgetragen. Die Teile der Abdeckschicht 5, die für deren Strukturierung entsprechend dem zu druckenden Muster entfernt werden müssen, werden also beim Entwickeln der Photolackschicht 6 gleich mit entfernt. Die bei der Entwicklung nicht abgetragenen Teile der Photolackschicht 6 schützen somit die nicht abzutragenden Teile derAbdeckschicht 5 und dienen damit als Strukturierungsmaske 6' für die Abdeckschicht 5.

Bei der Verwendung von lichthärtenden Photolacken, die nicht mit alkalischen Entwicklern bearbeitet werden, muß die Abdeckschicht 5 wenn sie eine Gelatineschicht ist, nach der Photolackentwicklung mit einer geringfügig alkalischen Lösung, z.B. einer Sodalösung, an den nicht mehr durch die Photolackschicht 6 abgedeckten Stellen entfernt werden. Dabei muß natürlich der abdeckende und lichtgehärtete Photolack der Lackschicht 6 eine hinreichende Widerstandsfähigkeit gegen die alkalische Lösung aufweisen.

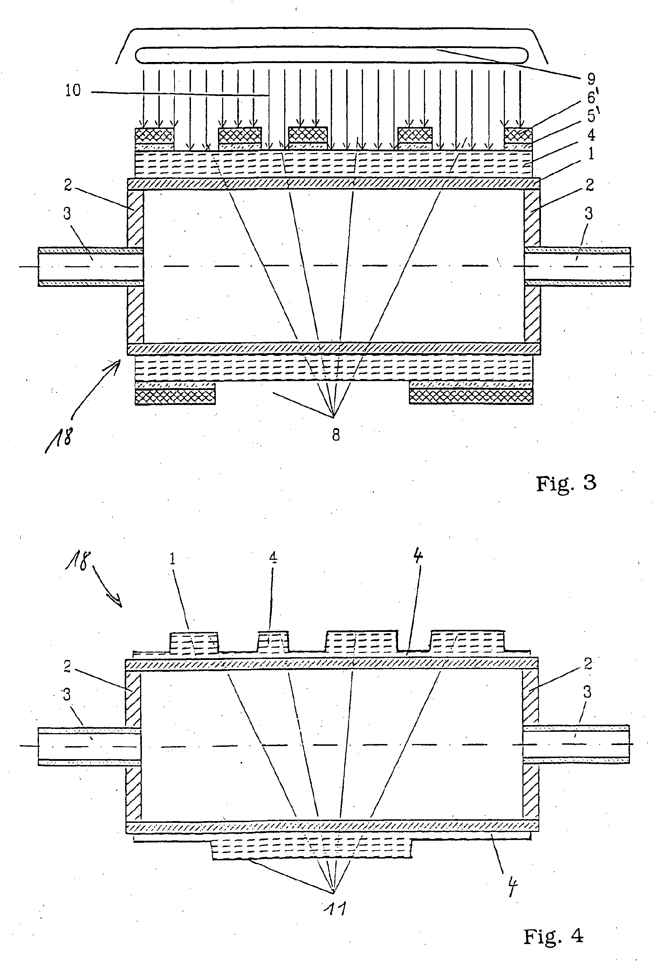

Als Resultat dieses Musterbildungsprozesses ergibt sich die in Fig.2 dargestellte Druckform 18, bei der die erste strahlungsempfindliche Schicht, also im Ausführungsbeispiel die Photoelastomerschicht 4 mit einer Bestrahlungsmaske 5' abgedeckt ist und somit mustergemäß freigelegte Stellen 8 aufweist, durch die die Belichtung der Photoelastomerschicht 4 erfolgen kann. Wie in Fig.3 dargestellt, erfolgt die Belichtung der Photoelastomerschicht 4 großflächig für mehrere Minuten mit einem von einer Lampe 9, insbesondere einer Xenonlampe erzeugten Lichtband 10. Anstelle der Xenonlampe kann auch eine Metall-Halogen-Dampflampe treten. Metall-Halogen-Dampflampen sind dabei energiebilanzmäßig vorteilhaft, da sie Licht nur im Bereich der Empfindlichkeitsmaxima der üblichen Photopolymere emittieren, und kaum Wärmestrahlung aussenden, so daß die Oberfläche der Druckform 18 nicht unzulässig erwärmt wird.

Die belichteten Stellen der Photoelastomerschicht 4 werden bei entsprechend langer Belichtungszeit tief und nachhaltig vernetzt. Hierbei ist es zweckmäßig die Photoelastomerschicht 4 nur solange mit der Lampe 9 zu belichten, bis die Versetzung für den nachfolgenden Entwicklungsvorgang an den belichteten Stellen 8 gerade ausreicht, das heißt, das die vernetzten Stellen dem chemischen und mechanischen Angriff während der Entwicklung gerade hinreichend widerstehen können. Dies hat den Vorteil, daß die von der Abdeckschicht 5 abgedeckten Bereiche der Photoelastomerschicht 4 selbst dann unvernetzt bleiben, wenn die UV-lichtdichte Abdeckung durch die Abdeckschicht 5 möglicherweise unvollständig ist, wenn also ein geringer Teil des auf die Abdeckschicht 5 auftreffenden UV-Lichts durch die Abdeckschicht 5 hindurch gelangen könnte.

Nach der in Fig.3 dargestellten Belichtung der Photoelastomerschicht 4 wird die Druckform 18 bzw. die Photoelastomerschicht 4 entwickelt, um die in Fig.4 dargestellte fertige Druckform 18 zu erhalten. Hierzu wird die Druckform in ein Entwicklungsbad mit einem wiederum alkalischen Entwickler gebracht. Dieser ist jetzt so alkalisch, daß die relativ dünne Photolackschicht 6, die beispielsweise etwa 10 µm dick ist, genauer gesagt die mustergemäß noch vorhandenen und gehärteten Bereiche dieser Photolackschicht 6 trotz ihrer Vernetzung sofort angegriffen und abgetragen werden. Dabeiwird auch die aus Gelatine oder Wachs bestehende Bestrahlungsmaske 5' entfernt. Selbst wenn diese beiden Schichten durch den zum Entwickeln des Photopolymers der Photoelastomerschicht 4 gebrauchten Entwickler nicht angegriffen werden, sind die während des Entwicklungsprozesses ausgeübten mechanischen Beanspruchungen der Abdeckschicht 5 und der Photolackschicht 6 so groß, daß die beiden relativ dünnen Schichten rein mechanisch sehr schnell abgetragen werden. Nachdem vollständigen Abtragen der Photolackschicht 6 und der Bestrahlungsmaske 5' hat der Entwickler ungehindert Zutritt zu den unbelichteten oder allenfalls nur schwach belichteten Stellen der Photoelastomerschicht 4 und beginnt das Photopolymer abzutragen. Unterstützt wird die chemische Entwicklung durch ein intensives mechanisches Bürsten der zu entwickelnden Photoelastomerschicht 4 im Entwicklerbad.

Bei der in Fig.4 dargestellten fertigen Druckform 18 nach dem Entwickeln entsprechen die erhabenen Stellen 11 den durch die Lichteinwirkung vernetzten Bereichen der Photopolymerschicht 4.

Zweckmäßigerweise wird das Verfahren für die Herstellung von zylindrischen Druckformen, insbesondere bei der Herstellung von zylindrischen Flexodruckformen mit Belichtungs- und Entwicklungseinrichtungen durchgeführt, wie sie im folgenden beschrieben werden.

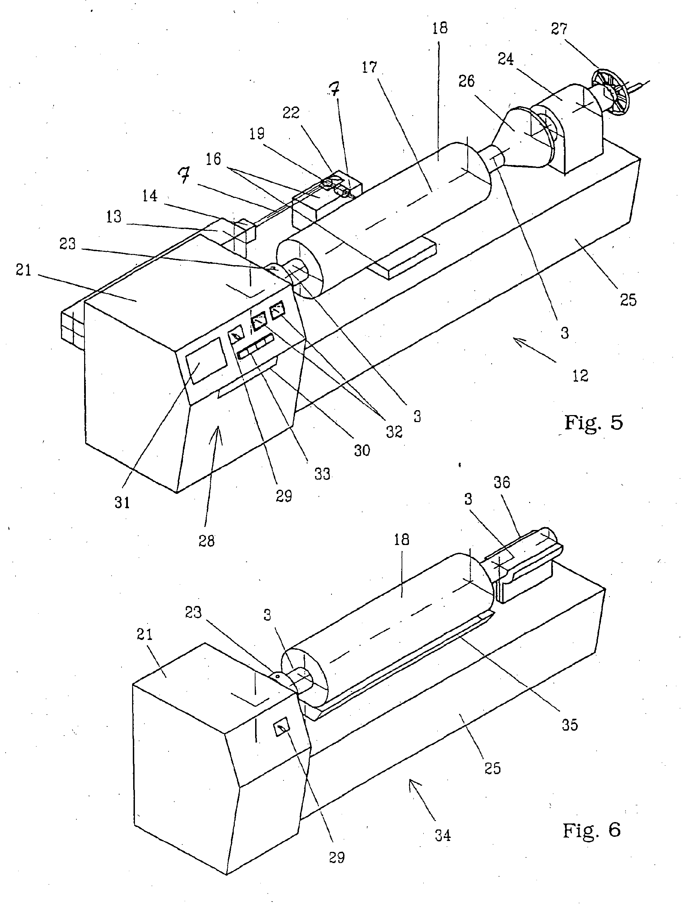

Obwohl die Belichtung der zweiten strahlungsempfindlichen Schicht, also der Photolackschicht 6 mit jeder auf die Empfindlichkeit der Photolackschicht 6 abgestimmten Strahlungs- oder Lichtquelle in jeder bekannten Weise erfolgen kann, wird diese Belichtung vorzugsweise mit einer Belichtungsvorrichtung 12 durchgeführt, wie sie in Figur 5 gezeigt ist. Die Belichtungsvorrichtung 12 weist einen Laser 13, insbesondere einen Argon-Ionen-Laser, auf, der den Laserstrahl 7 emittiert. Der Laserstrahl 7 besitzt dabei einen Durchmesser von etwa 1 bis 3 mm und einen sehr geringen Divergenzwinkel. Auf einem Schlitten 16, der in Richtung der Achse 17 der Druckform 18 langsam verfahren werden kann, ist ein Umlenkspiegel 19 montiert, der den Laserstrahl 7 auf die zylindrische Oberfläche der Druckform 18, also auf die zylindrisch liegende Photolackschicht 6 richtet. Vor der Auftreffstelle des Laserstrahls 7 auf die Druckform 18 ist eine Linsenanordnung oder eine Laseroptik 22 vorgesehen, die den Laserstrahl 7 im Bereich der Auftreffstelle auf einen Durchmesser von etwa 30 µm fokussiert. Obwohl die Druckform 18 praktisch rund läuft, kann es bei einzelnen Druckformen gelegentlich noch zu einem Rundlauffehler von etwa 0.1 mm kommen. Die Laseroptik 22 wird zweckmäßigerweise mit einer Brennweite von etwa 50 bis 150 mm ausgeführt. Bei einem Laser 13 mit geringem Strahldivergenzwinkel variiert der Durchmesser der Strahltaille im Bereich des Fokus bei einer Rundlaufabweichung der Druckform 18 von 0.1 mm um maximal 1%, so daß auf eine Nachführung oder Nachregelung der Laseroptik 22 verzichtet werden kann.

Während der mustergemäßen Belichtung der Photolackschicht 6 rotiert die Druckform 18 mit gleichmäßiger Geschwindigkeit, so daß der Belichtungslichtfleck auf der Photolackschicht 6, also auf der Oberfläche der Druckform 18 eine Schraubenlinie beschreibt. Die Rotationsbewegung wird der Druckform 18 dabei von einem in einem Spindelstock 21 untergebrachten Antrieb erteilt, mit welchem der linke Achsstummel 3 über ein Spannfutter 23 verbunden ist. Der rechte Achsstummel 3 der Druckform 18 wird dabei von einem Reitstock 24 gehalten. Unterhalb der Druckform 18 befindet sich das Bett 25 der Belichtungsvorrichtung 12, das den Spindelstock 21 mit dem Reitstock 24 ähnlich wie bei einer Drehbank verbindet. Das Bett 25 der Belichtungsvorrichtung 12 führt dabei den Schlitten 16 während seiner Bewegung parallel zur Achse 17 der Druckform 18.

Ein Stützkegel 26 am Reitstock 24 greift in das hohle Ende des rechten Achsstummels 3 ein und ist mittels eines Handrads 27 am Reitstock auf verschiedene Druckformlängen feinfühlig einstellbar. Eine zusätzliche Grobeinstellung kann durch Verschieben des Reitstocks 24 in Richtung der Achse 17 der Druckform 18 auf dem Bett 2 5 erfolgen. Am Spindelstock 21 ist ferner ein Bedienfeld 28 zu erkennen. Ein Hauptschalter 29 dient für das elektrische Anschließen an das bzw. für das Trennen vomNetz. Für die bequeme Einstellung verschiedener notwendiger Arbeitsparameter wie Maschinendrehzahl, Auflösung des Musters und dergleichen ist eine Eingabetastatur in einer ausziehbaren Lade 30 vorgesehen. Die Eingabedaten, der Arbeitsfortschritt und gegebenenfalls Störungsmeldungen werden über einen Monitor 31 ausgegeben. Auf dem Monitor 31 kann auch das jeweils abzuarbeitende Muster dargestellt werden. Für die Überwachung sehr wesentliche Betriebsdaten werden zusätzlich auf Instrumenten 32 laufend angezeigt. Die Schalterreihe 33 enthält einen Notstopptaster. Taster für das Zu- und Abschalten des Monitors 31 und Taster für das manuell gesteuerte Verschieben des Schlittens 16 während der Einrichtphase.

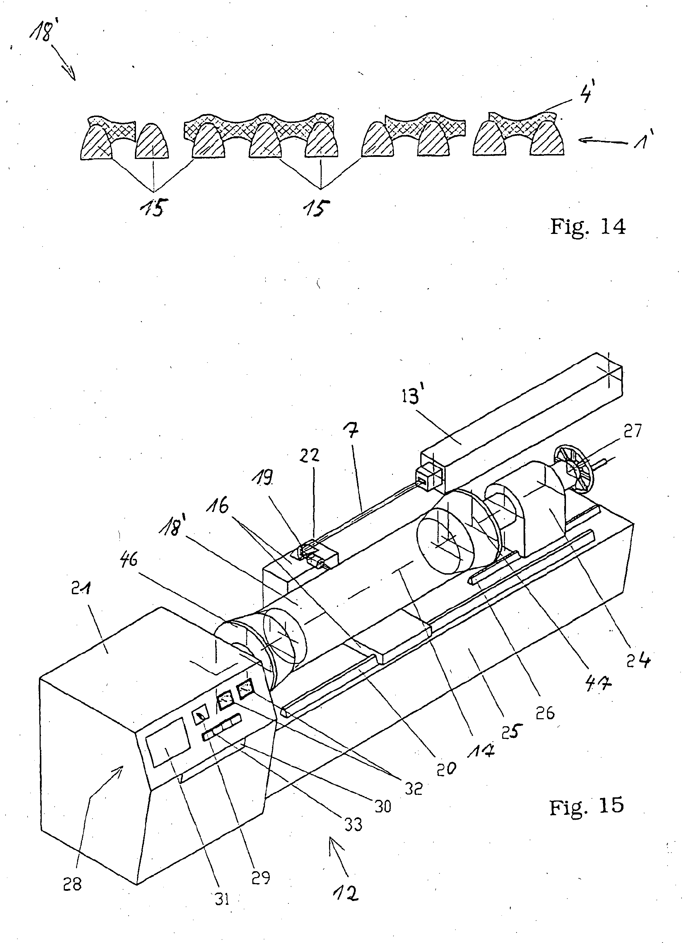

Die hier beschriebene Belichtungsvorrichtung 12 ist hinsichtlich der Halterung und dem Antrieb der Druckform 18 an eine Flexodruckform angepaßt, wie sie beispielsweise in Fig.4 gezeigt ist. Für andere zylindrische Druckformen, ist die Lagerung der zylindrischen Druckform und deren Antrieb in entsprechender Weise geeignet auszuführen, und ist beispielsweise für Siebdruckzylinder in Figur 15 gezeigt und wird weiter unten erläutert.

Anstelle der schraubenförmigen Belichtung der zylindrischen Photolackschicht 6 mit einem einzelnen Lichtfleck kann die Belichtung auch mit mehreren in Längsrichtung der Achse 17 der Druckform 18 nebeneinander angeordneten Lichtflecken gleichzeitig erfolgen. Dabei wird beispielsweise während einer Drehung der Druckform 18 ein zylindrischer Musterstreifen belichtet. Bei der folgenden Drehung wird dann der Schlitten 16 um die Breite des belichteten Musterstreifens verschoben um einen nahtlos daran anschließenden Musterstreifen bei der folgenden Drehung der Druckform 18 zu belichten wonach wiederum eine entsprechende Verschiebung des Schlittens 16 erfolgt.

Nach der Belichtung der Druckform 18 in der Belichtungsvorrichtung 12 erfolgt die Entwicklung der Photolackschicht 6 mit Hilfe eines flüssigen Entwicklers in einer Entwicklungsvorrichtung 34, wie sie beispielsweise in Fig.6 dargestellt ist. In dieser Entwicklungsvorrichtung rotiert die Druckform 18 nur langsam während ihre Oberfläche in eine flache Tasse 35, die den flüssigen Entwickler enthält, mit geringer Tiefe eintaucht. Angetrieben wird die Druckform 18 von einem Antrieb im Spindelstock 21 über ein Spannfutter 23, das den in Fig.6 linken Achsstummel 3 der Druckform 18 trägt. Der rechte Achsstummel 3 kann wegen der sehr geringen Drehzahl einfach in einer offenen Lagerhalbschale 36 abgestützt werden.

Mittels eines Hauptschalters 29 wird die Drehbewegung der Druckform 18 ein- bzw. ausgeschaltet. Für die Entwicklung ist ein Zeitaufwand von wenigen Minuten erforderlich. Nach Abschluß der Entwicklung sind je nach Art des verwendeten Lacktyps, also je nach dem ob ein mit Licht härtbarer oder mit Licht zersetzbarer Photolack die unbelichteten oder die belichteten Stellen der Photolackschicht 6 abgetragen. Bei der Entwicklung der Druckform 18 bzw. der Photolackschicht 6 wird meistens auch gleichzeitig die nicht mehr durch den Photolack der Photolackschicht 6 abgedeckten Stellen der Abdeckschicht 5 abgetragen. Sollte der Entwickler hierfür nicht geeignet oder erschöpft sein, dann kann auf derselben Entwicklungsvorrichtung mit einem anderen Bad auch die Abdeckschicht 5 abgetragen werden. Die letzten Reste des Entwicklers bzw. des letzten Bades werden nach Anschluß der Entwicklung durch Spülen mit Leitungswasser entfernt.

Die auf der in Fig.6 gezeigten Entwicklungsvorrichtung 34 entwickelte Druckform 18 weist den in Fig.2 dargestellten Schichtaufbau mit noch unbehandelter Photoelastomerschicht 4 und mustergemäß strukturierter Abdeckschicht 5 und Photolackschicht 6 auf.

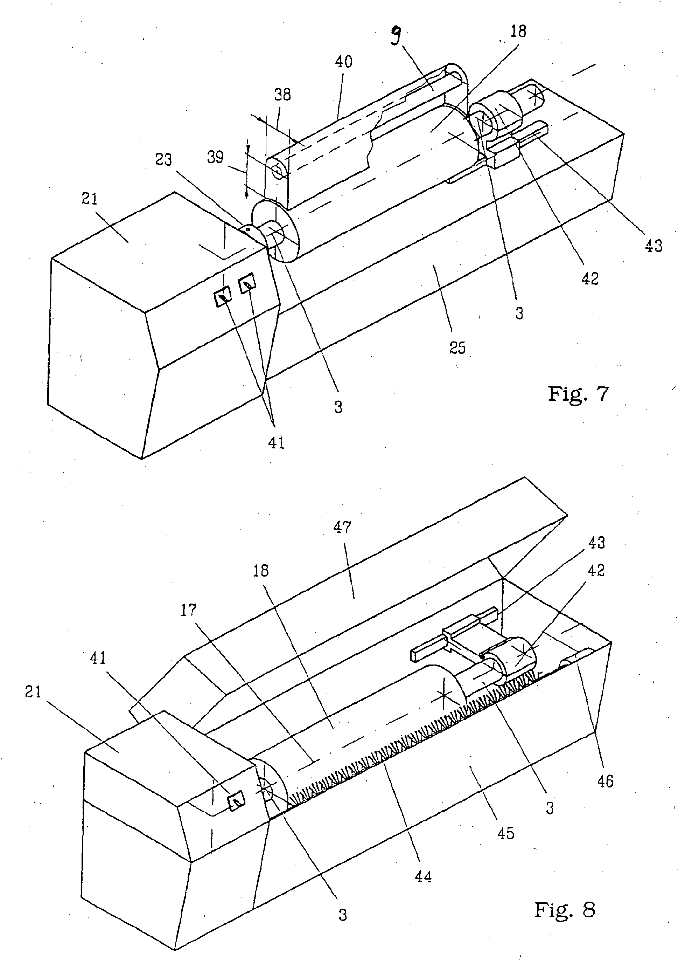

Die so vorbereitete Druckform 18 wird dann beispielsweise in einer Belichtungsvorrichtung, wie sie in Fig.7 gezeigt ist, großflächig belichtet. Hierfür weist die Belichtungsvorrichtung eine Lampe 9 auf, die beispielsweise eine Metall-Halogen-Dampflampe ist. Die Lampe 9 hat dabei zweckmäfügerweise die Form eines Lampenbalkens mit kreisrundem Querschnitt und erstreckt sich über die gesamte Länge der Druckform 18. Wesentlichen Einfluß auf die Qualität der Gravur haben die in Umfangsrichtung der Druckform 18 gesehene Breite 38 eines Lampengehäuses 40 und der Abstand 39 der Lampe 9 von der Druckform 18 in Radialrichtung. Die Breite 38 des Lampengehäuses 40 sollte ein Drittel des Durchmessers der Druckform 18 nicht überschreiten, da sonst durch Unterstrahlungseffekte auch die Randbereiche der durch die Abdeckschicht 5 abgedeckten Stellen der Photoelastomerschicht 4 vernetzt und damit gehärtet werden. Dies ist nicht erwünscht, da dadurch die Linienschärfe des Musters beeinträchtigt wird.

In besonderen Fällen wird die Breite 38 des Lampengehäuses 40 sogar nur auf etwa 10% des Durchmessers der Druckform 18 beschränkt. Ein größerer Abstand 39 und eine kleinere Breite 38 erhöht die Konturentreue, verlängert aber wegen der geringeren beleuchteten Fläche auf der Druckform 18 und der geringeren Beleuchtungsstärke die notwendige Belichtungszeit. Ein kleinerer Abstand 39 und eine größere Breite 38 bewirken das Gegenteil.

Am Spindelstock 21 sind je ein Schalter 41 für den Drehantrieb der Druckform 18 und die Lampe 9 vorgesehen. Zweckmäßigerweise sind die Schalter elektrisch so verriegelt, daß die Lampe 9 nur dann eingeschaltet werden kann, wenn die Druckform 18 bereits dreht. Der rechte Achsstummel 3 der Druckform 18 ist dabei in einem aufklappbaren Stützlager 42 drehbar gelagert, das auf einer Führung 43 in eine der Länge der Druckform 18 angemessene Position gebracht werden kann.

Nach der zweiten Belichtung der Druckform 18, also nach der großflächigen Belichtung der Photoelastomerschicht 4 wird die Druckform 18 in einer weiteren Entwicklungsvorrichtung abschließend entwickelt.

Wie in Fig.8 gezeigt, wird die Druckform 18 in einer Wanne 45 drehbankähnlich gelagert, so daß sie von einem nicht dargestellten Drehantrieb in einem Spindelstock 21 in Drehung versetzt werden kann. Durch die Betätigung eines Schalters 41 wird der Drehantrieb im Spindelstock 21 eingeschaltet und die Druckform 18 in drehende Bewegung versetzt. Außerdem wird eine Bürstwalze 44 mit relativ hoher Drehzahl angetrieben. Die Druckform schöpft aus einem nicht sichtbaren Entwicklersumpf in der Wanne 45 laufend Entwicklerflüssigkeit während zusätzlich auf die Bürstwalze 44 Entwicklerflüssigkeit aus einer durch die vordere Wand der Wanne 45 verdeckten und daher nicht sichtbaren Düsenleiste aufgespritzt wird.

Der intensive Kontakt der Photoelastomerschicht 4 der Druckform 18 mit der Entwicklerflüssigkeit und die intensive mechanische Abrasion durch die rotierende Bürstwalze 44 sorgen für ein rasches Abtragen bzw. Auswaschen aller nichtvernetzten Bereiche der Photopolymerschicht 4, von der nach Abschluß der Entwicklung nur die vernetzten Bereiche und eine dünne noch nicht vernetzte Basisschicht verbleiben, welche für die Befestigung des Photoelastomers am Trägerrohr 1 notwendig ist. Diese dünne Basisschicht 4 wird nicht aufgelöst und ausgewaschen, um auch kleinere vernetzte Bereiche des Photoelastomers zuverlässig am Trägerrohr 1 befestigen zu können.

Der Entwicklungsvorgang wird daher zu einem vorbestimmten Zeitpunkt abgebrochen.

Auch in der Entwicklungsvorrichtung wird der vom Spindelstock 21 abgewandte rechte Achsstummel 3 der Druckform 18 von einem einfachen Stützlager 42 gehalten, das auf einer Führung 43 in Richtung derAchse 17 der Druckform 18 verschiebbar angeordnet ist, um verschieden lange Druckform 18 in die Entwicklungsvorrichtung einlegen zu können.

Zum leichteren Einlegen und Herausnehmen der Druckform 18 ist das Stützlager 42 geteilt ausgeführt. Die obere Hälfte kann nach Entriegelung nach oben geklappt werden. Die Bürstwalze 44 ist an ihren beiden Enden in Gleitlagerbüchsen 46 drehbar gelagert. Da während des Entwicklungsvorgangs und dem hierzu notwendigen intensiven Bürsten der Oberfläche der Druckform 18 die Entwicklerflüssigkeit stark verspritzt wird, weist die Entwicklungsvorrichtung zweckmäßigerweise einen Klappdeckel 47 auf, der die Wanne 45 dicht verschließt.

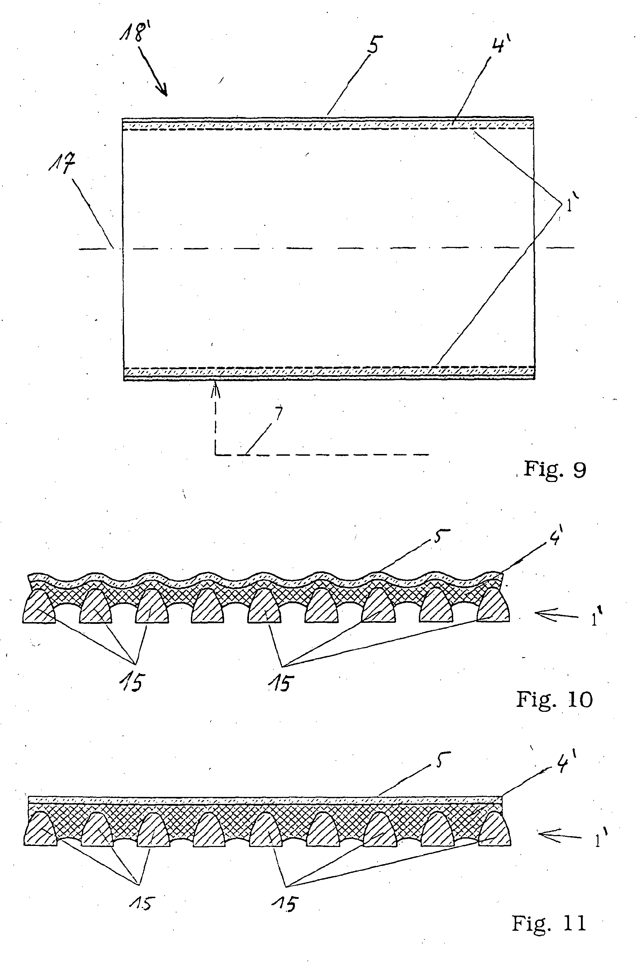

Ein Ausführungsbeispiel der Erfindung wird anhand der Herstellung einer Siebdruckschablone unter Bezugnahme auf die Figuren 9 bis 17 näher erläutert.

Die Figur 9 zeigt einen Rohling für eine Siebdruckschablone 18', die im folgenden der Einfachheit halber unabhängig von der Herstellungsstufe als solche bezeichnet wird. Die Siebdruckschablone 18' weist als Träger einen dünnen Siebzylinder 1' auf, auf den als erste strahlungsempfindliche Schicht eine Photolackschicht 4' gelegt ist, die mit einer Abdeckschicht 5 überzogen ist. Die Photolackschicht 4' kann aus Gelatine oder Polyvinylalkohol bestehen, die mit Kaliumbichromat versetzt wird. Bei Einwirkung kurzwelliger Strahlung im UV-Bereich vernetzt eine so behandelte Gelatine oder ein so behandelter Polyvinylalkohol auch im trockenen Zustand und der Lack wird damit wasserunlöslich und wesentlich beständiger gegenüber chemischen Angriffen, wie diese etwa bei Einwirkung eines Entwicklers oder von Druckchemikalien auftreten.

Die nicht vernetzte bzw. nicht gegerbte Gelatine und ebenso der nicht gegerbte Polyvinylalkohol läßt sich hingegen durch warmes Wasser oder eine alkalische wässrige Lösung sehr leicht herauswaschen. Dieser Vorgang wird als Entwicklung bezeichnet.

Für die Photolackschicht 4' kann auch Epoxy- oder Methylmethacrylat verwendet werden. Diese Harze werden meist mit einem alkoholischen oder ketonischen Lösemittel verdünnt oder in Form einer wässrigen Emulsion solcher Lösungen verwendet und enthalten häufig zur Steigerung der Lichtempfindlichkeit oder der Verlagerung der Empfindlichkeit in einen längerwelligen Lichtbereich einen optischen Sensibilisator. Auch so aufgebaute Photolackschichten werden durch die Einwirkung von Licht photosynthetisch vernetzt bzw. gehärtet.

Für die Abdeckschicht 5 werden die gleichen Lösungsmittel, schichtbildenden Substanzen und UV-absorbierenden oder UV-reflektierenden Stoffe eingesetzt wie bei der anhand des Beispiels zum besseren Verständnis der Erfindung beschriebenen Abdeckschicht 5. Neben der Verwendung von schwarzen Pigmenten, wie z. B. Ruß (Black Carbon) können bei Abdeckschichten auch andere Farbstoffe wie beispielsweise Sudan Blue der Firma BASF oder Kombinationen von farbigen Farbstoffen, wie eine Mischung aus Sudan Blue Farbstoff mit Novaperm Yellow Pigment der Firma Hoechst eingesetzt werden.

Das Auftragen der Photolackschicht 4' und der Abdeckschicht 5 erfolgt vorzugsweise mit dem oben beschriebenen Tauchbeschichtungsverfahren. Dies hat insbesondere für das Aufbringen der Abdeckschicht 5 den vorteil, daß diese Schicht selbst dann mit über die gesamte Siebdruckschablone gleicher Dicke aufgetragen werden kann, wenn die Photolackschicht 4' infolge eines trocknungsbedingten Schrumpfens eine wellige Oberfläche aufweist, wie beispielsweise in Figur 10 dargestellt.

Es ist noch darauf hinzuweisen, daß die Photolackschicht 4' vor dem Aufbringen der Abdeckschicht 5 und ebenso die Abdeckschicht 5 nach ihrem Aufbringen getrocknet werden, wenn diese Schichten Wasser oder andere Lösungsmittel enthalten. Das Trocknen wird dabei meist in einem Warmluftofen ausgeführt, in dem die Umluft kontinuierlich gefiltert wird.

In Figur 10 ist zu erkennen, daß der Siebzylinder 1' aus einzelnen Stegen 15 besteht, die galvanoplastisch aufgebaut sind. Anstelle eines galvanoplastisch aufgebauten Siebzylinders 1' kann auch ein Siebzylinder aus einem Metallgewebe verwendet werden. Darüber hinaus ist es insbesondere bei ebenen Siebdruckschablonen möglich, Textilgewebe einzusetzen, insbesondere feines Seidengazegewebe, um die mit der fertigen Siebdruckschablone erzielbare Druckqualität weiter zu verbessern. Bei der Verwendung von Textilgeweben ist es zwecksmäßig, eine die Siebstruktur nicht beeinträchtigende Metallbeschichtung vorzusehen, um beim Abtragen der Abdeckschicht 5 und beim Belichten der Photolackschicht 4' eine Beschädigung des Siebgewebes durch die verwendete Strahlung zu verhindern.

Die in Figur 10 dargestellte Photolackschicht 4' zeigt eine unebene Oberfläche, da sie aus einem stark Lösemittel haltigem Lack aufgebaut ist, wodurch die Photolackschicht 4' während derTrocknungdurch das Abdampfen des Lösemittels stark geschrumpft ist. Die Photolackschicht 4' in Figur 11 besteht hingegen aus einem polymerisierenden Lacksystem, so daß diese Schicht geringfügig schrumpft und somit eine ebene bzw. glatte Oberfläche beibehält.

Die auf die Photolackschicht 4' nach Figur 10 aufgetragene Abdeckschicht 5 bleibt dank des verwendeten Tauchbeschichtungsverfahrens überall gleich dick.

Um eine mustergemäß strukturierte Strahlungsmaske 5' zu erhalten, wird die Abdeckschicht 5 mustergemäß abgetragen.

Erfindungsgemäß wird jedoch die Abdeckschicht mit Hilfe von Laserstrahlung abgetragen. Vorzugsweise wird hier Laserstrahlung verwendet, deren Wellenlänge vom nahen Infrarotbereich (800 nm bis 1 µm bei Verwendung von Laserdioden; 1 ,06 µm bei Verwendung eines Nd-YAG-Lasers) bis zum thermischen Strahlungsbereich (10,6 µm bei einem CO₂-Laser reicht. Das Abtragen der Abdeckschicht 5 erfolgt dabei durch Abdampfen. Es ist jedoch auch möglich, die Abdeckschicht 5 durch Photolyse abzutragen, wobei dann auch kürzere Wellenlängen, die im sichtbaren Bereich liegen, zur Anwendung gelangen. Eine Strahlung im UV-Bereich und im kurzwelligen Spektralbereich des sichtbaren Lichtes mit Wellenlängen bis etwa 500 nm wird allerdings nur dann verwendet, wenn die unter der Abdeckschicht 5 liegende Photolackschicht 4' unter der Einwirkung der später erfolgenden großflächigen Nachbelichtung vernetzt bzw. härtet, also aus einem polymerisierenden Harzsystem aufgebaut ist.

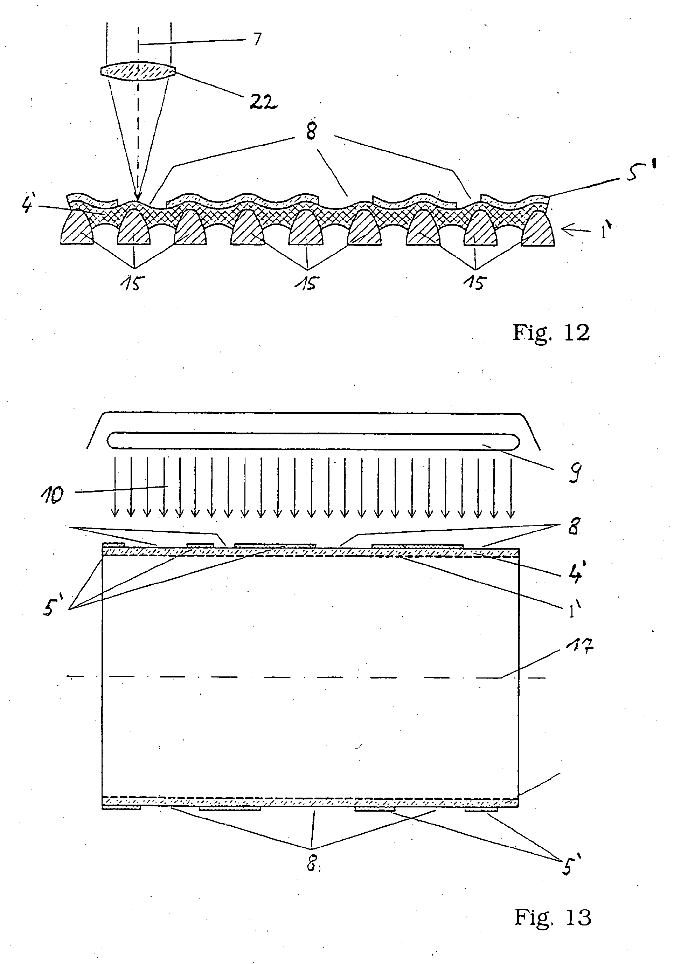

Figur 12 zeigt eine aus der Abdeckschicht 5 hergestellte Bestrahlungsmaske 5', die mustermäßig so durch die thermische Wirkung eines Laserstrahls 7 abgelöst wurde, daß die Photolackschicht 4' musterbedingt freigelegte Stellen 8 aufweist, an denen die Photolackschicht 4' bei der nachfolgenden, in Figur 13 gezeigten großflächigen Belichtung entweder photo-lytisch geschädigt oder aber gehärtet werden soll.

Der zum unmittelbaren musterbedingten Abtragen der Abdeckschicht 5 eingesetzte Laserstrahl 7 wird durch eine Laseroptik 22 so fokussiert, daß er an der Auftreffstelle einen Durchmesser von 20 bis 40 µm aufweist. Der verwendete Laserstrahl 7 hat dabei vor der Laseroptik 22 einen kleinen Strahldivergenzwinkel, so daß bei den verwendeten Brennweiten zwischen 50 nm und 150 nm eine Strahltaille im Fokus, also an der Auftreffstelle entsteht, die sich in einem Bereich von 0,1 mm senkrecht zur Oberfläche des Siebzylinders 1' gemessen nur um wenige Prozente ändert, so daß ein Rundschlag in der Größenordnung von 0,1 mm praktisch keinen Einfluß auf die Konturtreue der Gravur hat.

Nach der erfindungsgemäß mit einem Laser durchgeführten mustergemäßen Abtragung der Abdeckschicht 5 zur Ausbildung einer Bestrahlungsmaske 5' wird die Photolackschicht 4' großflächig mit einem von einer Lampe 9 emittierten Lichtband belichtet. Als Lampe 9 wird dabei vorzugsweise eine Metallhalogenlampe verwendet. Bei diesem Lampentyp liegen die Maximalwerte der Emissionsenergie bei Wellenlängen zwischen 290 und 540 nm, so daß die Photolackschicht also mit energiereicher UV-Strahlung bestrahlt wird, die starke photochemische Wirkungen nach sich zieht. Die Photolackschicht 2 wird an den bestrahlten Stellen gehärtet. Im Falle von Lacken, die unter der Einwirkung von UV-Strahlung vernetzt sind, wird die Photolackschicht 4' an den bestrahlten Stellen chemisch sehr widerstandsfähig und die nicht bestrahlten Stellen dieser Schicht können während der nachfolgenden Entwicklung durch Warmwasser vom Siebzylinder l'abgelöst werden. Figur 14 zeigt eine unter Verwendung eines Positivlacks hergestellte Siebdruckschablone 18' im vergrößerten Schnitt.

Die in Figur 15 gezeigte Belichtungsvorrichtung 12, auf der das laseroptische Ablösen der Abdeckschicht 5 zur Ausbildung einer Bestrahlungsmaske 5' entsprechend den Erfordernissen des in die Photolackschicht 4 einzubringenden Musters durchgeführt wird, ist ähnlich wie eine Drehbank aufgebaut. Ein Neodym-Yag Laser 13' emittiert einen Laserstrahl 7, der eine Wellenlänge von 1.06 µm und einen Durchmesser von wenigen Millimetern sowie einen sehr geringen Divergenzwinkel aufweist. Gegebenenfalls werden diese Eigenschaften des Laserstrahls 7 durch eine Aufweitungsoptik, die knapp hinter dem Austrittsfenster des Laser vorgesehen sein kann. sichergestellt.

Anstelle eines Nd-YAG-Lasers, der durch Laserdioden gepumpt wird, kann auch ein CO₂-Laser eingesetzt werden, der durch Ein- und Ausschalten einer elektrischen Entladungsstrecke gepulst wird. Im letzteren Fall lassen sich Schaltfrequenzen von 10 bis 20 kHz erreichen, während durch Ein- und Ausschalten der Laserdioden im ersten Fall Schaltfrequenzen bis et-wa 50 kHz erreichbar sind. Falls noch höhere Schaltfrequenzen benötigt werden, kann der Laser auch im Dauerbetrieb arbeiten und der Strahl mit einem akusto- oder elektrooptischen Schalter unterbrochen werden.

Der Vorteil einer Abtragung der Abdeckschicht 5 mit einer Wellenlänge oberhalb von 800 nm besteht darin, daß weder eine Vorvernetzung noch eine photolytische Zersetzung der unter der Abdeckschicht 5 liegenden Photolackschicht 4' erfolgen kann, weil für beide Effekte Licht mit höherer Quantenenergie und somit kürzerer Wellenlänge erforderlich ist. Natürlich ist eine genaue Dosierung der optischen Strahlenergie des Laserstrahls 7 erforderlich, da sich die Photolackschicht 4' sonst thermisch zersetzen kann.

Auf einem Schlitten 16, der in Richtung der Achse 17 der Siebdruckschablone 18' langsam verfahren wird, ist ein Umlenkspiegel 19 montiert, der den Laserstrahl 7 auf die Oberfläche der Siebdruckschablone 18' richtet. Zur Fokussierung des Laserstrahls 7 ist dabei eine Laseroptik 22 hinter dem Umlenkspiegel 19 vorgesehen.

Während der Belichtung rotiert die Siebdruckschablone 18' mit gleichmäßiger Geschwindigkeit, so daß der Lichtfleck des Laserstrahls 7 eine Schraubenlinie auf der Oberfläche der Siebdruckschablone 18' beschreibt. Diese Rotationsbewegung wird der Siebdruckschablone 18' von einem im Spindelstock 21 untergebrachten Antrieb erteilt, mit welchem die linke Stirnseite der Siebdruckschablone 18' über einen Mitnahmekonus 46 verbunden ist. Die rechte Stirnseite der Siebdruckschablone 18' wird von einem Zentrierkonus 47 am Reitstock 24 gehalten.

Unterhalb der Siebdruckschablone 18' befindet sich das Bett 25 der Belichtungsvorrichtung 12, das den Spindelstock 21 mit dem Reitstock 24 verbindet und Führungen 20 für den Schlitten 16 trägt; die diesen während seiner Arbeitsbewegung genau parallel zur Achse 17 der Siebdruckschablone 18' führen.

Um verschieden lange Siebdruckschablonen 18' bearbeiten zu können, ist der Reitstock 24 in Axialrichtung verstellbar, während der Zentrierkonus 47, der in das rechte stirnseitige Ende einer Siebdruckschablone 18' eingreift zur Feineinstellung mittels eines Handrades 27 am Reitstock 24 fein verstellbar ist.

Am Spindelstock 24 sind ferner die gleichen Bedienungs- und Anzeigeeinrichtungen angeordnet, wie sie bei der anhand von Figur 5 beschriebenen Belichtungsvorrichtung 12 ebenfalls vorgesehen sind.

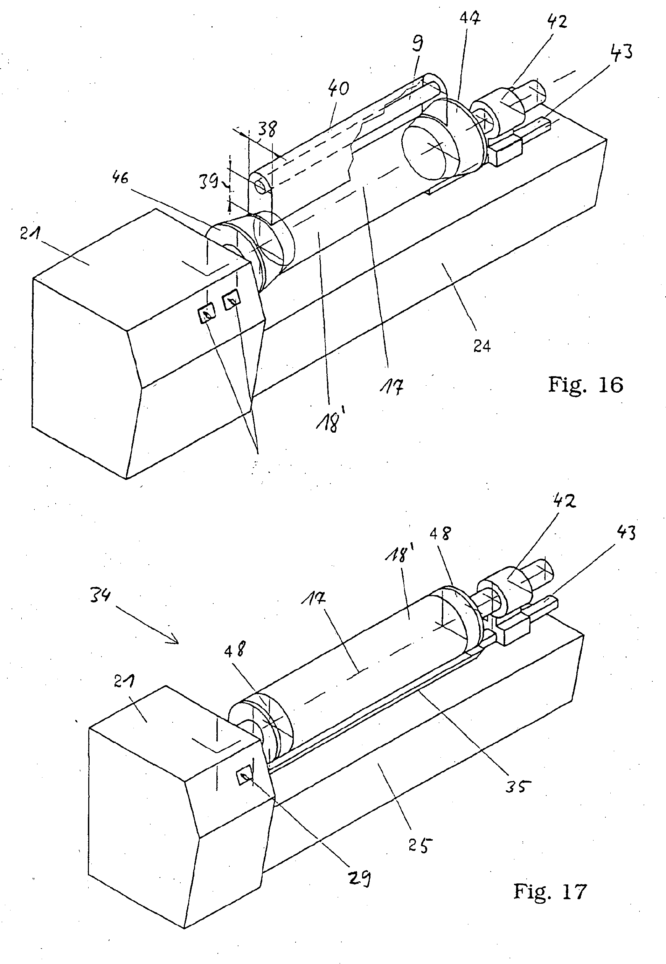

Nach dem mustergemäßen Abtragen der Abdeckschicht 5 mittels Laserstrahlung zur Ausbildung der Bestrahlungsmaske 5' erfolgt die großflächige Belichtung durch eine Lampe 9 auf einer Belichtungsvorrichtung durchgeführt, die schematisch in Figur 16 dargestellt ist. Die Lampe 9 hat dabei die Form eines Lampenbalkens mit kreisrundem Querschnitt und erstreckt sich über die gesamte Länge der Siebdruckschablone 18'. Obwohl als Lampe 9 unter anderem auch eine Xenondampflampe eingesetzt werden kann, ist eine Metallhalogendampflame hinsichtlich ihrer Energiebilanz vorteilhaft, wenn der verwendete Photolack im UV-Bereich empfindlich ist, da ihre Energiebilanz besser ist, wie oben bereits erläutert wurde.

Die Breite 38 des Lampengehäuses 40 und der Abstand 39 der Lampe 9 von der Oberfläche der Siebdruckschablone 18' haben den bereits bei der Erläuterung der in Figur 7 gezeigten Belichtungseinrichtung beschriebenen Einfluß auf Belichtungszeit und Konturtreue und werden entsprechend gewählt. Abgesehen von dem Mitnahmekonus 46 und dem Zentrierkonus 47 zur Lagerung der Siebdruckschablone 18' ist die Lichtungsvorrichtung nach Figur 16 ebenso aufgebaut, wie die anhand von Figur 7 beschriebene Belichtungsvorrichtung, so daß hier auf eine erneute Beschreibung verzichtet wird.

Nach der großflächigen Belichtung erfolgt die Entwicklung der Photolackschicht 4' auf einer Entwicklungsvorrichtung 34, die in Figur 17 dargestellt ist, und bis auf die Lager für die Siebdruckschablone 18' der in Figur 6 dargestellten Entwicklungsvorrichtung 34 entspricht.

Wurde für die Photolackschicht 4' ein vernetzender Lack z. B. aus Epoxydharz-, Gelatine- oder Polyvinylalkoholbasis verwendet, so erfolgt die Entwicklung der Photolackschicht 4' einfach durch Spülen mit warmen oder heißen Wasser, in dem die Siebdruckschablone 18' über einem Auffangbecken für das mit Harzresten versetzte Abwasser mit einer Handbrause abgespült wird.

Obwohl anhand der Zeichnung nur die Herstellung zylindrischer Druckformen gezeigt und erläutert wurde, kann das erfindungsgemäße Verfahren auch bei ebenen Druckplatten angewendet werden.

Bei plattenförmigen Druckformen kann dabei die Strukturierung der Abdeckschicht 5, also die Belichtung oder Bestrahlung der zweiten strah, lungsempfindlichen Schicht mit einem Belichtungskopf durchgeführt werden, der in zwei vorzugsweise senkrecht aufeinander stehenden Richtungen über der Druckplatte verschiebbar ist.

## Patentansprüche

1. Verfahren zum Herstellen einer Druckform, bei dem
- auf eine auf einem Sieb (1') angeordnete erste strahlungsempfindliche Photolackschicht (4') aus einem vernetzbaren Lack mittels Tauchbeschichtung eine Abdeckschicht (5) aufgetragen wird, wobei die Abdeckschicht (5) feine lichtabsorbierende oder lichtreflektierende Partikel enthält, die in Gelatine oder Polyvinylalkohol suspendiert sind,
- die aufgetragene Abdeckschicht (5) nach einem Trocknungsschritt entsprechend einem Muster strukturiert wird, wobei zur Strukturierung der Abdeckschicht (5) musterbedingt zu entfernende Teile der Abdeckschicht (5) unmittelbar unter Verwendung von Laserstrahlung abgetragen werden, um eine Bestrahlungsmaske (5') zu bilden, und
- die erste strahlungsempfindliche Photolackschicht (4') bestrahlt und durch Spülen mit Wasser entwickelt wird.

2. Verfahren nach Anspruch 1, **dadurch gekennzeichnet, dass** für die Photolackschicht (4') ein vernetzbarer Lack auf Epoxydharz-, Gelatine- oder Polyvinylalkoholbasis verwendet wird.

3. Verfahren nach Anspruch 1 oder 2, **dadurch gekennzeichnet, dass** die Photolackschicht (4') bestrahlt und durch Spülen mit warmen oder heißen Wasser entwickelt wird.

4. Verfahren nach Anspruch 1, 2 oder 3, **dadurch gekennzeichnet, dass** die mustergemäß strukturierte Abdeckschicht (5), also die Bestrahlungsmaske (5') beim Entwickeln der Photolackschicht (4') entfernt wird.

5. Verfahren nach einem der Ansprüche 1 bis 4, **dadurch gekennzeichnet, dass** die mustergemäße Bestrahlung der Abdeckschicht (5) punktweise erfolgt.

6. Verfahren nach Anspruch 5, **dadurch gekennzeichnet, dass** bei der punktweisen Bestrahlung mehrere nebeneinander liegende Musterpunkte mittels einer entsprechenden Anzahl von Bestrahlungspunkten gleichzeitig mustergemäß bestrahlt werden.

7. Verfahren nach einem der vorstehenden Ansprüche, **dadurch gekennzeichnet, dass** die Suspension von feinen Metallpartikeln in Gelatine durch Reduktion von in Gelatine gelösten Metallsalzen, insbesondere Silberhalogeniden, hergestellt wird.

8. Verfahren nach einem der vorstehenden Ansprüche, **dadurch gekennzeichnet, dass** die Abdeckschicht (5) 1 µm bis 20 µm, vorzugsweise 7 µm bis 14 µm, insbesondere 10 µm dick ist.

9. Verfahren nach einem der vorstehenden Ansprüche, **dadurch gekennzeichnet, dass** die Photolackschicht (4') mit einem Tauchbeschichtungsverfahren auf das Sieb (1') aufgebracht wird.

10. Verfahren nach Anspruch 9, **dadurch gekennzeichnet, dass** die Photolackschicht (4') aus Gelatine oder Polyvinylalkohol gebildet ist, wobei der Gelatine bzw. dem Polyvinylalkohol ein photosensibles Gerbmittel, beispielsweise Kaliumbichromat, beigefügt ist.

11. Verfahren nach einem der vorstehenden Ansprüche, **dadurch gekennzeichnet, dass** der Photolackschicht (4') Stoffe zum Vergrößern ihrer Elastizität beigefügt sind, um eine Rissbildung zu verhindern.

12. Verfahren nach einem der vorstehenden Ansprüche, **dadurch gekennzeichnet, dass** das Sieb (1') metallisch ist.

13. Verfahren nach einem der Ansprüche 1 bis 11, **dadurch gekennzeichnet, dass** das Sieb (1') aus einem Textilgewebe, insbesondere aus einem Seidengazegewebe, gebildet ist, das vorzugsweise durch eine chemische und/oder galvanische Metallabscheidung verstärkt ist.

14. Verfahren nach einem der vorstehenden Ansprüche, **dadurch gekennzeichnet, dass** das Sieb (1') flach ist.

15. Verfahren nach einem der Ansprüche 1 bis 13, **dadurch gekennzeichnet, dass** das Sieb (1') zylindrisch ist.

## Claims

1. Process for producing a printing form, in which
- a covering layer (5) is applied, using an immersion-coating process, onto a first radiation-sensitive photoresist layer (4') which is arranged on a screen (1') and which is composed of a curable resist, wherein the covering layer (5) comprises fine light-absorbing or light-reflecting particles suspended in gelatin or polyvinyl alcohol,
- the applied covering layer (5), after a drying step, being structured in accordance with a pattern, wherein, for the structuring of the covering layer (5), parts of the covering layer (5) which must be removed owing to the pattern are removed directly using laser radiation in order to form an irradiation mask (5'), and
- the first radiation-sensitive photoresist layer (4') is irradiated and is developed by flushing with water.

2. Process according to Claim 1, **characterized in that** a curable resist based on epoxy resin, gelatin or polyvinyl alcohol is used for the photoresist layer (4').

3. Process according to Claim 1 or 2, **characterized in that** the photoresist layer (4') is irradiated and is developed by flushing with warm or hot water.

4. Process according to Claim 1, 2 or 3, **characterized in that** the covering layer (5) structured in accordance with the pattern, that is to say the irradiation mask (5'), is removed during the development of the photoresist layer (4').

5. Process according to one of Claims 1 to 4, **characterized in that** the irradiation of the covering layer (5) in accordance with the pattern is performed point by point.

6. Process according to Claim 5, **characterized in that**, during the point-by-point irradiation a plurality of pattern points located alongside one another are irradiated simultaneously in accordance with the pattern by means of an appropriate number of irradiation points.

7. Process according to one of the preceding claims, **characterized in that** the suspension of fine metal particles in gelatin is produced by reduction of metal salts, in particular silver halides, dissolved in gelatin.

8. Process according to one of the preceding claims, **characterized in that** the covering layer (5) is 1 µm to 20 µm, preferably 7 µm to 14 µm, in particular 10 µm, thick.

9. Process according to one of the preceding claims, **characterized in that** the photoresist layer (4') is applied to the screen (1') using an immersion-coating process.

10. Process according to Claim 9, **characterized in that** the photoresist layer (4') is formed from gelatin or polyvinyl alcohol, the gelatin or polyvinyl alcohol having a photosensitive tanning agent, for example potassium dichromate, added to it.

11. Process according to one of the preceding claims, **characterized in that** the photoresist layer (4') has substances added to it to increase its elasticity, in order to prevent the formation of cracks.

12. Process according to one of the preceding claims, **characterized in that** the screen (1') is metallic.

13. Process according to one of Claims 1 to 11, **characterized in that** the screen (1') is formed from a textile fabric, in particular from a silk gauze fabric, which is preferably reinforced by the deposition of metal, chemically and/or by electroplating.

14. Process according to one of the preceding claims, **characterized in that** the screen (1') is flat.

15. Process according to one of Claims 1 to 13, **characterized in that** the screen (1') is cylindrical.

## Revendications

1. Procédé pour fabriquer un cliché d'impression, dans lequel
- sur une première couche de photo-laque (4') sensible au rayonnement, disposée sur un tamis (1') en une laque susceptible d'être réticulée est appliquée une couche de couverture (5) au moyen d'un revêtement par immersion, ladite couche de couverture (5) contenant des fines particules absorbant la lumière ou réfléchissant la lumière, qui sont mises en suspension dans de la gélatine ou de l'alcool polyvinylique,
- la couche de couverture (5) appliquée est structurée, après une étape de séchage, de manière correspondante à un motif, de sorte que pour la structuration de la couche de couverture (5) des parties à enlever en fonction du motif de la couche de couverture (5) sont enlevées immédiatement en utilisant un rayonnement laser pour former un masque d'irradiation (5'), et
- la première couche de photo-laque (4') sensible au rayonnement est irradiée et développée par rinçage avec de l'eau.

2. Procédé selon la revendication 1, **caractérisé en ce que** l'on utilise pour la couche de photo-laque (4) une laque susceptible d'être réticulée à base de résine époxy, de gélatine ou d'alcool polyvinylique.

3. Procédé selon la revendication 1 ou 2, **caractérisé en ce que** la couche de photo-laque (4') est irradiée et est développée par rinçage avec de l'eau chaude ou bouillante.

4. Procédé selon la revendication 1, 2 ou 3, **caractérisé en ce que** la couche de couverture (5) structurée selon le motif, donc le masque d'irradiation (5'), est supprimée lors du développement de la couche de photo-laque (4').

5. Procédé selon l'une des revendications 1 à 4, **caractérisé en ce que** l'irradiation de la couche de couverture (5) selon le motif a lieu en mode point par point.

6. Procédé selon la revendication 5, **caractérisé en ce que** lors de l'irradiation point par point, on irradie simultanément selon le motif plusieurs points du motif disposés les uns à côté des autres au moyen d'un nombre correspondant de points d'irradiation.

7. Procédé selon l'une des revendications précédentes, **caractérisé en ce que** la suspension de fines particules de métal dans de la gélatine est réalisée par réduction de sels métalliques dissous dans de la gélatine, en particulier d'halogénures d'argent.

8. Procédé selon l'une des revendications précédentes, **caractérisé en ce que** la couche de couverture (5) est d'une épaisseur de 1 µm à 20 µm, de préférence de 7 µm à 14 µm, en particulier de 10 µm.

9. Procédé selon l'une des revendications précédentes, **caractérisé en ce que** la couche de photo-laque (4') est appliquée au moyen d'un procédé de revêtement par immersion sur le tamis (1').

10. Procédé selon la revendication 9, **caractérisé en ce que** la couche de photo-laque (4') est réalisée en gélatine ou en alcool polyvinylique, de sorte que l'on ajoute à la gélatine ou à l'alcool polyvinylique un agent tannant photosensible, par exemple du bichromate de potassium.

11. Procédé selon l'une des revendications précédentes, **caractérisé en ce que** l'on ajoute à la couche de photo-laque (4') des substances pour augmenter son élasticité, afin d'empêcher une formation de fissures.

12. Procédé selon l'une des revendications précédentes, **caractérisé en ce que** le tamis (1') est métallique.

13. Procédé selon l'une des revendications 1 à 11, **caractérisé en ce que** le tamis (1') est formé d'un tissu textile, en particulier d'un tissu en gaze de soie, renforcé de préférence par dépôt métallique effectué par voie chimique et/ou galvanique.

14. Procédé selon l'une des revendications précédentes, **caractérisé en ce que** le tamis (1') est plat.

15. Procédé selon l'une des revendications 1 à 13, **caractérisé en ce que** le tamis (1') est cylindrique.
